# EUROPÄISCHE PATENTSCHRIFT

(11) **EP 3 346 494 B1**
(45) Veröffentlichungstag und Bekanntmachung des Hinweises auf die Patenterteilung: **13.11.2019**
(21) Anmeldenummer: 18150172.7
(22) Anmeldetag: 03.01.2018
(51) Int. Cl.: H01L 23/66, H01L 23/552, H01L 23/31, H01L 23/367, H01L 23/48, H01L 23/498, H01Q 1/22, H01Q 19/06, H01L 23/00

(54) **WAFER LEVEL PACKAGE MIT ZUMINDEST EINEM INTEGRIERTEN ANTENNENELEMENT**
WAFER LEVEL PACKAGE WITH AT LEAST ONE INTEGRATED ANTENNA ELEMENT
ENSEMBLE DE NIVEAU DE TRANCHE POURVU D'AU MOINS UN ÉLÉMENT D'ANTENNE INTÉGRÉ

(30) Priorität: 05.01.2017 DE 102017200121
(43) Veröffentlichungstag der Anmeldung: 11.07.2018
(73) Patentinhaber: Fraunhofer-Gesellschaft zur Förderung der angewandten Forschung e.V., 80686 München (DE)
(72) Erfinder: NDIP, Ivan, 13469 Berlin (DE); BRAUN, Tanja, 14052 Berlin (DE)
(74) Vertreter: Pfitzner, Hannes

(56) Entgegenhaltungen:
- DE-A1-102010 001 407
- US-A1- 2008 186 247
- US-A1- 2012 313 253
- US-A1- 2015 194 388

## Beschreibung

Ausführungsbeispiele der vorliegenden Erfindung beziehen sich auf ein Wafer Level Package mit zumindest einem integrierten Antennenelement sowie auf ein entsprechendes Herstellungsverfahren. Bevorzugte Ausführungsbeispiele beziehen sich auf eine Fan-Out-Panel-/Wafer Level-basierte System-Integrationsplattform mit Superstrate integrierten Antennen oder Antennenarray/Gruppenstrahler ohne Umverdrahtungsschicht.

Um dem steigenden Bedarf an mehr Bandbreite, höherer Datenrate, kleinerer Latenz und größerer Datensicherheit nachzukommen, werden für die Entwicklung drahtloser Systeme Chips mit höheren Betriebsfrequenzen (z. B. in Mikrowellen und Millimeterwellen Frequenzbereiche) eingesetzt. Aber je höher die Frequenz, desto größer ist die Dämpfung der Übertragungsstrecke. Um diese Dämpfung zu überwinden, müssen die drahtlosen Systeme über Antennen mit hoher Effizienz und Gewinn verfügen. Antennen sind die wesentlichen Elemente von Drahtlossystemen.

In drahtlosen Systemen sind Antennen entweder im Chip, auf dem Interposer oder auf der Leiterplatte (System-Board) integriert. Chip-integrierte Antennen können zu einer höheren Systemminiaturisierung und Kostenreduktion führen, weil sie zusammen mit dem Chip gleichzeitig hergestellt werden können. Außerdem ist die elektrische Verbindung zwischen einem Front-End Chip und einer Antenne sehr kurz. Solche Antennen haben jedoch eine sehr geringe Effizienz und einen geringen Antennengewinn, was auf die höhere Permitivität von Chip, Substraten sowie der Substrat- und Metallisierungsverluste der Chiptechnologien zurückzuführen ist. Deshalb sind sie für die Entwicklung künftiger Hochfrequenzsystemen ungeeignet. Antennen, die entweder auf dem Interposer oder auf der Leiterplatte integriert sind, können eine viel höhere Effizienz und Antennengewinn haben, solange die Antennen mit Hochfrequenzsubstraten hergestellt sind.

Der Signalpfad zwischen einem Front-end Chip und einer auf einem Interposer oder einer Leiterplatte integrierten Antenne ist aber lang und besteht aus vielen geometrischen Diskontinuitäten (z. B. Chipverbindungen wie Drahtbonds, Leitungen mit Knicken, Durchkontaktierungen usw.). Dieser Pfad verursacht Signalintegritätsprobleme wie Reflexion, Dämpfung, Signalverzögerung, Übersprechen und auch unerwünschte Strahlung, welche die gesamte Systemleistung verschlechtern.

Um diese Probleme zu vermeiden, müssen die Antennen ganz dicht zum Front-end Chips integriert werden. Dafür sind Systemintegrationsplattformen, die eine solche Integration ermöglichen, unabdingbar.

Im Stand der Technik gibt es einige Ansätze, wie die Systemintegration bewerkstelligt wurde. Fan-Out-Wafer Level Package (FO-WLP) basierte Systemintegrationsplattformen haben das Potenzial solche Integration zu gewährleisten. Beim FOWLP werden keine Interposer verwendet, hier kann die Integration von Antennen auf demselben Substrat, in die Chips eingebettet sind, erfolgen. Dadurch wird der Signalpfad zwischen den Chips und der Antenne reduziert und die Signalintegritätsprobleme vermindert.

Die drei führenden Beispiele von FO-WLP-basierten Systemintegrationsplattformen sind:
- Embedded Wafer Level Ball Grid Array (eWLB) von Infineon [1]
- Redistributed Chip Package (RCP) von Freescale [2]
- Integrated Fan-Out WLP (InFO-WLP) von TSMC [3]

Bisher wurden eWLB und InFO-WLP für drahtlose Systeme eingesetzt und demonstriert. Folgende Abbildung stellt eWLB und InFO-WLP mit integrierten Antennen dar

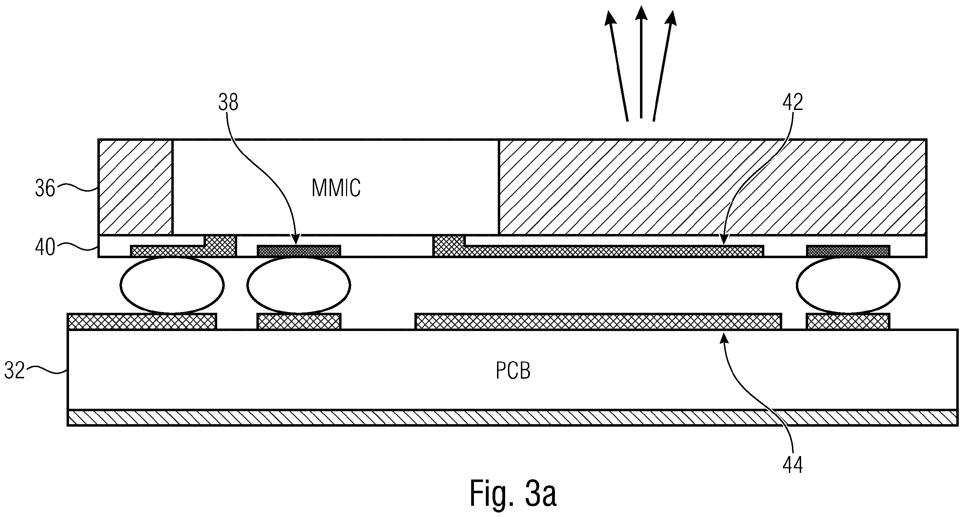

Fig. 3a zeigt eine Kombination aus PCB 32 mit eWLB 36, das einen Chip (z. B. RF-Chip) 38 sowie eine in der Umverdrahtungsschicht 40 des eWLB 36 angeordnete Antenne 42 umfasst. Zur Verbesserung der Signalabstrahlcharakteristik ist gegenüber von der Antenne 42 auf dem PCB Board 32 ein Reflektor 44 vorgesehen.

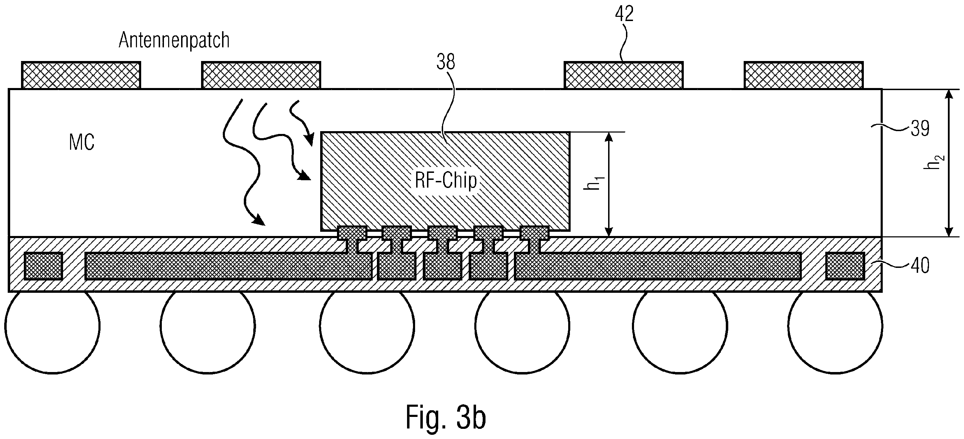

Fig. 3b zeigt eine InFO-WLB-Integration. Hier ist der Chip 38 in ein Gussharz 39 eingebettet, wobei auf der Unterseite des Chips die Umverdrahtungsschicht 40 vorgesehen ist. Auf der gegenüberliegenden Seite zu der Umverdrahtungsschicht 40 sind Antennenelemente 42 angeordnet.

In eWLB wird das strahlende Element der Antenne auf der Umverdrahtungslage (engl. Redistribution Layer - RDL) und der Reflektor auf der Leiterplatte integriert. Dadurch hängt die Funktionalität der Antennen und auch der Plattform von den Abmessungen der Packagekontaktierung z. B. BGA Balls und deren Prozessschwankungen sowie von der Leiterplattentechnologie ab. Dadurch kann die FOWLP Systemintegrationsplattform nur in Verbindungen mit den Kontakten/BGA Balls, der Leiterplatten Technologien und der Underfill Materialen optimiert werden.

Die Antennen in eWLB und InFO können nicht optimiert werden, ohne die Abmessungen der RDL und des Moldmaterials anzupassen, was die Designfreiheit der Plattform begrenzt.

Sowohl in eWLB als auch in InFO sind die Felder der integrierten Antennen nicht von den Chips und anderen integrierten Komponenten geschirmt. Die unerwünschte Wechselwirkung kann zu EMV Problemen führen.

In eWLB kann die Strahlung einer integrierten Antenne nicht die ganze Halbkugel (die gesamte horizontale und vertikale Ebene) abdecken, ohne unerwünschte Kopplung mit anderen integrierten Komponenten zu verursachen. Der Grund dafür ist, dass andere Komponenten auf derselben Ebene wie die Antennen integriert sind. Deshalb besteht der Bedarf nach einem verbesserten Ansatz.

DE10 2010 001 407 beschreibt ein Halbleitermodul mit integrierter Antenne. US 2015 0194388 offenbart ein geschirmten Halbleitermodul mit integrierter Antenne.

Aufgabe der vorliegenden Erfindung ist es ein Konzept zu schaffen, das es ermöglicht, ein Antennenelement in ein System derart zu integrierten, dass die Integration einen verbesserten Kompromiss aus Übertragungseffizienz, Designfreiheit und Vermeidung von unerwünschten Wechselwirkungen bzw. Kopplungen schafft.

Die Aufgabe wird durch den Gegenstand der unabhängigen Patentansprüche gelöst.

Ausführungsbeispiele der vorliegenden Erfindung schaffen ein Wafer Level Package (WLB), mit zumindest einer integrierten Antenne (z.B. ein Antennenarray oder Gruppenstrahler). Das Wafer Level Package umfasst eine Chipschicht mit mindestens einem Chip, wie z. B. einem RF-Chip (Radiofrequenzchip, Front-End) sowie eine Dielektrikumschicht. Zwischen der Chipschicht und der Dielektrikumschicht ist eine Antennenschicht mit der zumindest einen integrierten Antenne vorgesehen. Entsprechend weiteren Ausführungsbeispielen weist dieses Wafer Level Package keine Umverdrahtungsschicht auf.

Ausführungsbeispielen der vorliegenden Erfindung liegt die Erkenntnis zugrunde, dass durch das Vermeiden einer Umverdrahtungsschicht das Abstrahlverhalten signifikant verbessert werden kann. Deshalb werden die strahlende Elemente der Antenne zwischen der Ebene, in welcher der Chip angeordnet ist, und der sogenannten Dielektrikumschicht vorgesehen. Dies bietet entsprechend Ausführungsbeispielen auch den Vorteil, dass die Antenne direkt mit dem Chip verbunden werden kann.

Entsprechend weiteren Ausführungsbeispielen kann unterhalb der Dielektrikumschicht, d. h. also auf der zu der Chipschicht gegenüberliegenden Seite eine Kontaktierungsschicht vorgesehen sein. Über diese Kontaktierungsschicht kann das gesamte Wafer Level Package dann von Extern, z. B. über eine Lötverbindung, kontaktiert werden. Diese Kontaktierungsschicht weist eine Mehrzahl von Kontakten auf. Die Dielektrikumschicht wird dann im Regelfall mittels Vias durchkontaktiert, so dass die Kontakte der Kontaktierungsschicht mit dem Chip elektrisch verbunden sind.

Entsprechend Ausführungsbeispielen umfasst die Chipschicht nicht ausschließlich Chips, sondern auch den sogenannten Fan-out-Bereich, in welchem andere Elemente, wie z. B. passiven Elementen (wie z. B. Induktivitäten, Widerstände, Kondensatoren, Filter) oder andere Elemente oder anderen ICs zusammen mit einem Füll-Material, wie z. B. einem Polymer angeordnet sein können.

Entsprechend Ausführungsbeispielen ist die Antenne versetzt zu dem Chip der Chipschicht angeordnet. Alternativ wäre auch eine partielle Überlappung möglich. Bei einer derartigen Überlappung kann dann beispielsweise die direkte Kontaktierung realisiert werden. Um Antennenelement und Chip voneinander bezüglich EMV zu entkoppeln, kann in der Chipschicht, z. B. neben dem Chip bzw. allgemein zwischen Chip und Antennenelement, ein sogenanntes Schirm-Via vorgesehen sein. Dieses Schirm-Via verhindert Beeinflussungen des Chips von der Antennenstrahlung und auch umgekehrt eine Verhinderung der Beeinflussung der Sende- und Empfangseigenschaften der Antenne durch EMVrelevante Aktivitäten des Chips.

Entsprechend weiteren Ausführungsbeispielen kann die Dielektrikumschicht im Bereich der integrierten Antenne perforiert sein oder mittels eines Spacers versehen sein. Zusätzlich kann entsprechend weiteren Ausführungsbeispielen ein Schild auf der gegenüberliegenden Seite der Dielektrikumschicht vorgesehen sein. Dieses Schild ist beispielsweise zusammen mittels der Kontaktierungsschicht herstellbar.

Entsprechend weiteren Ausführungsbeispielen weist das Wafer Level Package auf einer der Dielektrikumschicht gegenüberliegenden Seite Mittel zum Temperaturabfüheren für den Chip auf.

Weitere Ausführungsbeispiele schaffen ein Verfahren zur Herstellung des Wafer Level Package mit den drei Schritten "Bereitstellen der Dielektrikumschicht", Anordnen der Antennenschicht auf der Dielektrikumschicht" und Anordnen der Chipschicht auf der Antennenschicht".

Weiterbildungen sind in den Unteransprüchen definiert.

Ausführungsbeispiele der vorliegenden Erfindung werden nachfolgend anhand der beiliegenden Zeichnungen erläutert. Es zeigen:
- Fig. 1: eine schematische Darstellung eines Wafer Level Package mit mindestens einem integrierten Antennenelement gemäß einem Basisausführungsbeispiel;
- Fig. 2a: eine schematische Schnittdarstellung eines Wafer Level Package gemäß einem Ausführungsbeispiel;
- Fig. 2b: eine weitere schematische Schnittdarstellung eines Wafer Level Package gemäß einem erweiterten Ausführungsbeispiel;
- Fig. 2c: eine schematische Schnittdarstellung eines Wafer Level Package mit Linse gemäß einem Ausführungsbeispiel;
- Fig. 2d: eine schematische Schnittdarstellung eines Wafer Level Package mit Gehäuse gemäß einem Ausführungsbeispiel; und
- Fig. 3a und 3b: schematische Darstellungen von Stand der Technik Ansätzen zur Integration von Antennen in die Waferschicht.

Bevor nachfolgend Ausführungsbeispiele der vorliegenden Erfindung anhand der beiliegenden Zeichnungen erläutert werden, sei darauf hingewiesen, dass gleichwirkende Elemente und Strukturen mit gleichen Bezugszeichen versehen sind, so dass die Beschreibung derer aufeinander anwendbar bzw. austauschbar ist.

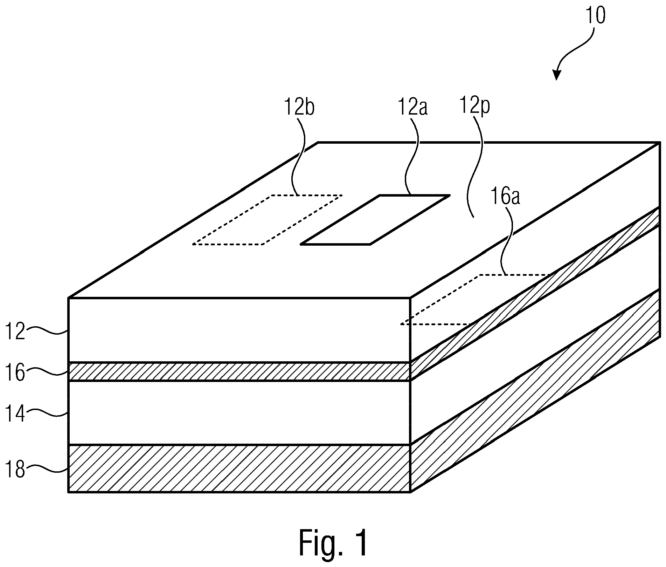

Fig. 1 zeigt ein Wafer Level Package 10 umfassend die zwei Schichten Chipschicht 12 und Dielektrikumschicht 14. Zwischen der Chipschicht 12 und der Dielektrikumschicht 14 ist eine sogenannte Antennenschicht 16 vorgesehen. Optionaler Weise kann eine Kontaktierungsschicht 18 an der Dielektrikumschicht 14, nämlich auf der gegenüberliegenden Seite zu der Schicht 16 vorgesehen sein.

Die Chipschicht 2 kann ein oder mehrere Chips, hier 12a und 12b, wie z. B. RF-Chips des Front-Ends umfassen. Diese Chips sind in die Schicht 12 eingebettet. Direkt angrenzend hierzu ist in der Antennenschicht 16 zumindest ein Antennenelement 16a vorgesehen. Hierbei sei angemerkt, dass dieses Antennenelement 16 bevorzugterweise außerhalb der Projektionsflächen der Chips 12a und 12b bzw. maximal teilweise überlappend mit den Projektionsflächen angeordnet ist. In anderen Worten ausgedrückt heißt das, dass die Antenne in dem Antennensubstrat (Kombination aus den Schichten 14 und 16) als sogenannte Superstrate integrierte Antenne designed ist. Das Hauptdielektrikum der Antenne ist durch die Dielektrikumschicht 14 geformt. Das sogenannte Superstrate ist das Polymer, in welchem die Chips 12a und 12b eingebettet sind (vgl. Bezugszeichen 12p). Auf diesem Polymer kann auch ein weiteres Antennenelement integriert werden, so dass ein multi-layered Antennensystem ausgebildet wird, wobei beispielsweise die untere Antennenelemente die obere Antennenelemente anregen, um z.B. größere Bandbreite zu erzielen. Das Einbetten kann beispielsweise mittels eines Fan-Out-Panel-/Wafer-Level-Prozess erfolgen.

Die integrierten Antennen können entsprechend weiteren Ausführungsbeispielen auch "intelligent", d. h. rekonfigurierbar, steuerbar, adaptiv bzw. smart ausgeführt sein. Die hierfür regelmäßig erforderliche Elektronik (z. B. Schaltungen und/oder Dioden) für die Rekonfigurierbarkeit kann entweder im Fan-out Bereich oder in der Dielektrikumschicht mitintegriert sein. Hierbei wäre es auch entsprechend weiteren Ausführungsbeispielen denkbar, dass die Elektronik für die Steuerung der Antenne (z. B. Phasenschieber) entweder in der im Fan-out Bereich oder in der Dielektrikumschicht angeordnet ist.

Entsprechend bevorzugten Ausführungsbeispielen ist die aktive Seite des bzw. der Chips 12a und 12b in Kontakt mit dem Antennenelement 16a, d. h. also ohne Umverdrahtungsschicht (RDL). Das Vermeiden der Umverdrahtungsschicht bietet einerseits Vorteile hinsichtlich des Abstrahlverhaltens und andererseits den wesentlichen Vorteil, dass Antenne und Chip direkt miteinander, d. h. ohne Zwischenverbinder, in elektrischem Kontakt stehen. Durch die Vermeidung der Umvedrahtungslage werden auch die Bauteils-Kosten reduziert.

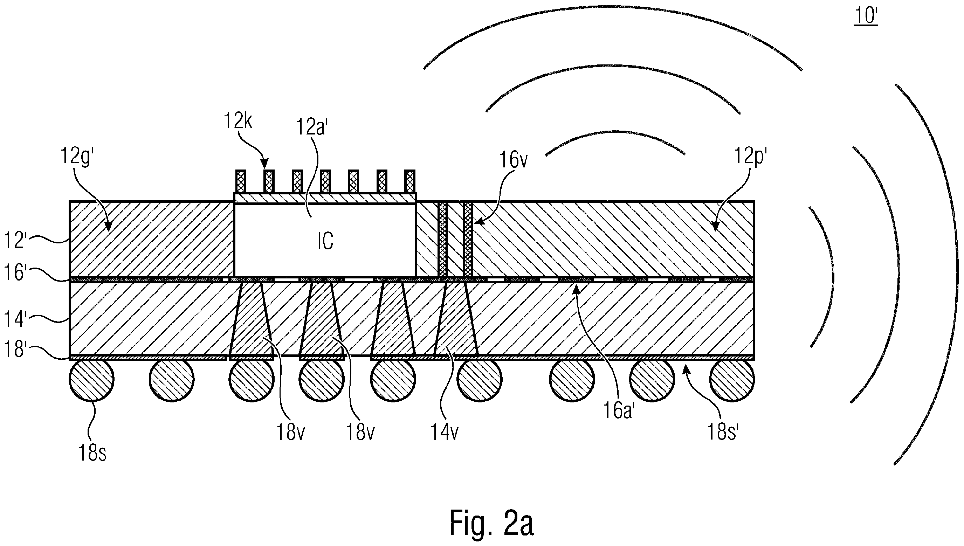

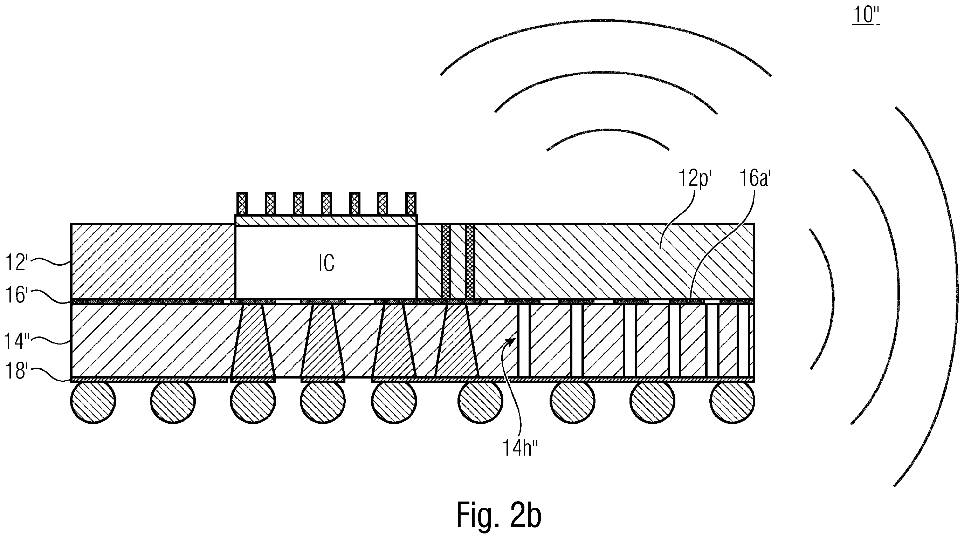

Wie bereits oben angedeutet, kann das Wafer Level Package 10 auch noch zusätzlich die Kontaktierungsschicht 18 aufweisen. Über diese werden die Chips 12a und 12b bzw. allgemein die gesamte elektrische Schaltung, welche in dem Wafer Level Package 10 realisiert, kontaktiert. Auch wäre es denkbar, dass in dieser Kontaktierungsschicht 18 die Funktionalität der Umverdrahtung, z. B. um die Chips 12a und 12b zu verbinden, integriert sein kann. Bezug nehmend auf Fig. 2a und 2b werden nun optionale Elemente erläutert, z. B. wie die Kontaktierungsschicht 18 mit den Chips 12a und 12b miteinander verknüpft ist.

Fig. 2a zeigt ein Wafer Level Package 10', das die Chipschicht 12', die Dielektrikumschicht 14' sowie die dazwischenliegende Antennenschicht 16' aufweist. Zusätzlich weist das Wafer Level Package 10' auch noch die Kontaktierungsschicht 18' auf.

In der hier dargestellten Darstellung wird ersichtlich, dass in der Chipschicht 12' der eine IC 12a' angeordnet ist. Dieser ist lateral eingebettet in weitere Bauelemente, wie z. B. weitere ICs, passive oder andere Systemkomponenten oder ein einfaches Polymer, wie z. B. ein Gussharz. Die lateral neben dem IC 12a' angeordneten Bereiche nennen sich Fan-Out-Area, welche mit dem Bezugszeichen 12p' im Bereich der Antenne und 12g' auf der anderen Seite versehen sind.

Die Antenne 16a', hier beispielsweise eine Einelementantenne oder ein Antennenarray, ist eben im Bereich 12p' in der Antennenschicht 16', d. h. also lateral neben dem Chip 12a' angeordnet. Auf der Chipschicht kann eine weitere Antennenelemente oder Antennenarray über 16a' angebracht werden.

Herstellungstechnisch wird die Antenne 16a' bzw. die Antennenschicht 16' auf das Dielektrikum 14' aufgebracht, so dass insgesamt das Antennensubstrat 14' plus 16' entsteht.. Aus Herstellungssicht kann es sinnvoll sein, zusammen mit der Antennenschicht 16' die Kontaktierungsschicht 18' herzustellen, wobei hier dann also die Vorderseite und die Rückseite metallisiert werden.

Nach dem Herstellen des zweiseitig metallisierten Antennensubstrats 14' plus 16 kann dann in einem nächsten Schritt die Chipschicht 12' aufgebracht werden. Hierbei werden die zwei Ebenen 12' und 14' plus 16' plus 18' zueinander ausgerichtet, dass der IC 12a' mit der Antenne 16a' kontaktiert wird. Die Kontaktierung kann, wie bereits oben erläutert, entweder direkt erfolgen oder entsprechend einem alternativen Ausführungsbeispiel auch über die Vias unter Zuhilfenahme der Kontaktierungsschicht 18'.

Die Vias sind in diesem Ausführungsbeispiel mit dem Bezugszeichen 18v versehen und erstrecken sich durch das gesamte Dielektrikum 14', so dass der IC 12a' mittels der Kontaktierungsschicht 18' kontaktierbar ist. Entsprechend optionalen Ausführungsbeispielen kann zur Kontaktierung je Via 18v bzw. allgemein je Kontaktpunkt ein Lötpunkt (Solder Ball) 18s vorgesehen werden. Die Lötpunkte können verwenden werden, um weitere WLP zu kontaktieren.

Entsprechend weiteren Ausführungsbeispielen ist auf der Sichtlinie zwischen dem IC 12a' und der Antenne 16a' ein sogenanntes Schirm-Via (TMV) bzw. eine Reihe von Schirm-Vias 16v in der Sicht 12' bzw. 14v in der Schicht 14' vorgesehen, die ausgebildet sind, um die gegenseitige elektromagnetische Beeinflussung von IC 12a' und Antenne 16a' zu verhindern oder zu reduzieren. Hier ist eine Reihe von Vias 16v vorgesehen. Diese erstrecken sich optionaler Weise auch mittels eines weiteren Vias 14v in die Dielektrikumschicht 14'.

Entsprechend weiteren Ausführungsbeispielen kann im Bereich der Antenne 16a' bzw. im Bereich des Fan-Out-Bereichs 12p' ein Schirm 18s' vorgesehen sein, der durch die Kontaktierungsschicht 18' gebildet ist.

Der Schirm 18s' zusammen mit den Schirm-Vias 16v' bzw. 14v' ermöglichen eine Abstrahlung der Antenne 16a' beispielsweise nach oben, d. h. aus dem Chipsubstrat 12' heraus sowie zur Seite. Allgemein kann festgestellt werden, dass in Abhängigkeit von der jeweiligen Antennenkonfiguration die Abstrahlung nur aus der Schichtfläche heraus oder nur aus der Seitenfläche heraus oder aus beiden Flächen heraus erfolgen kann. Dieser letzte Fall ist in diesem Ausführungsbeispiel dargestellt.

Bei obigen Ausführungsbeispielen wurde davon ausgegangen, dass eine Verbindung zwischen Antenne 16a' und Chip 12a' eine direkte Verbindung ist. An dieser Stelle sei darauf hingewiesen, dass auch die Verbindung mittels eines Vias hergestellt werden kann.

Da bei diesem Ausführungsbeispiel die Chipschicht 12' den Toplayer formt, kann die offene Oberfläche dazu genutzt werden, um eine Wärmeabfuhr für den Chip 12a' zu realisieren. Optionaler Weise kann auch noch ein Kühlkörper bzw. allgemein Kühlmittel 12k vorgesehen sein, die auf dem IC 12a' angeordnet sind. Der Kühlkörper 12k ist ausgebildet, die Wärme des Chips 12a' in die Umgebung abzuführen.

Fig. 2b zeigt eine weitere Wafer Level Package Anordnung 10" mit den Schichten 12', 16', 18' sowie einer modifizierten Dielektrikumschicht 14".

Bei der hier illustrierten Dielektrikumschicht 14" handelt es sich um eine derartige, die im Bereich der Antenne 16a' bzw. allgemein im Fan-Out-Bereich 12p' perforiert ist. Die eingebrachten Löcher sind mit dem Bezugszeichen 14h" versehen. Die Löcher 14h" verursachen ein Verhalten einer photonischen Bandpassstruktur, die die Oberflächenwellen filtert. Die Löcher können ebenso die effektive Er reduzieren. Somit können Strukturen mit größeren Dimensionen genutzt werden, um Millimeter-Wellen und Terahertz-Frequenzen zu übertragen. Diese Maßnahme reduziert den Einfluss von Prozesstoleranzen bei der Herstellung. Alternativ wäre es auch möglich, dass eine elektromagnetische Bandpassstruktur anstatt der photonischen Bandpassstruktur genutzt wird, um das Rauschen herauszufiltern.

Da die Wafer Level Packages 10, 10', 10" typischerweise auf Leitplatten, wie z. B. PCB Boards unter Zuhilfenahme der Lötpunkte 18s aufgebracht werden, wäre es auch denkbar, dass über diese Leiterplatte die Kontaktierung zwischen dem Chip 12a' und der Antenne 16a' erfolgt.

Gemäß einem weiteren Ausführungsbeispiel wird ein System geschaffen, bei dem das Wafer Level Package mit (zumindest) einem weiteren (andersartigem oder gleichem) Wafer Level Package verbunden ist. Die Vebindung erfolgt z.B. über die Kontaktierungsschicht. Das weitere Wafer Level Package kann z.B. ebenfalls ein oder mehrerer Antennen (Array) umfassen, sodass im Ergebnis eine dreidimensionale Antennenstruktur geschaffen wird.

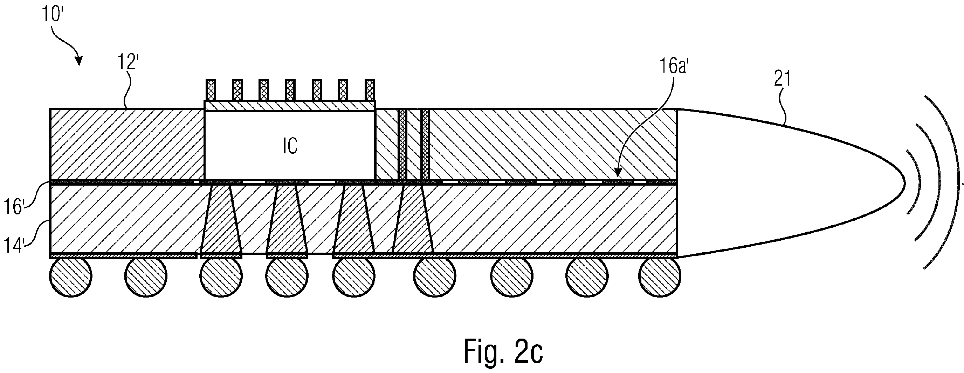

Fig. 2c zeigt das Wafer Level Package 10' aus Fig. 2a mit Chipschicht 12', Dielektrikumschicht 14' sowie dazwischenliegender Antennenschicht 16'. In diesem Ausführungsbeispiel weist das Wafer Level Package 10' eine zusätzliche Linse 21 (Mittel zur Strahlformung der der elektromagnetischen Welle ausgesendet durch die Antenne) an einer Stirnseite (benachbart zur Antenne 16a') auf. Diese dient zur Fokussierung des Antennenstrahls (hier zur Seite). Alternativ oder additiv kann die Linse auch auf der Ober- oder Unterseite (Hauptoberfläche) angeordnet sein, so dass eine vertikale Fokussierung erfolgt.

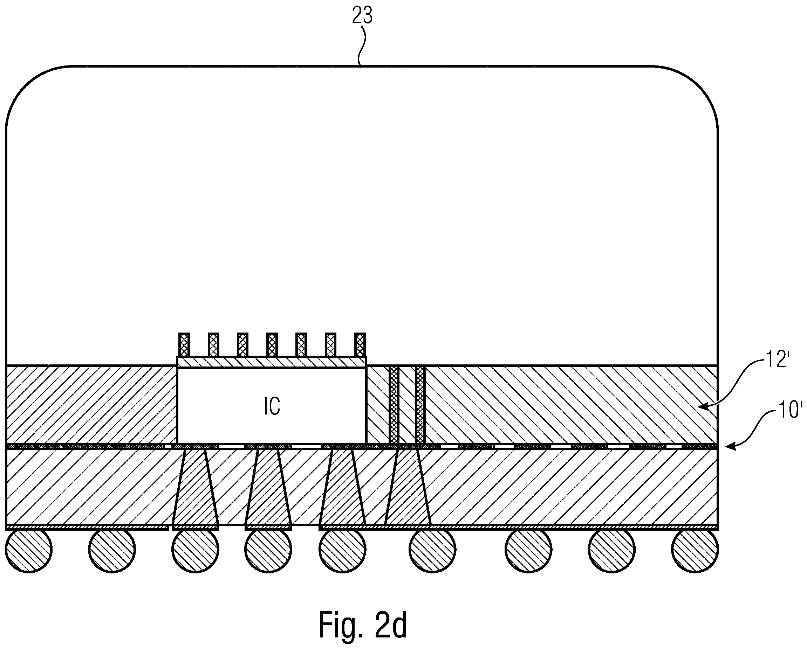

Fig. 2d zeigt wiederum das Wafer Level Package 10' aus Fig. 2a in Kombination mit einem auf der Oberseite (Seite der Chipschicht 12') angeordneten Gehäuse 23. Das Gehäuse 23 ist bevorzugt aus Glas oder einem anderen nicht schirmenden Material. Das Gehäuse 23 kann z.B. mit Luft oder einem dielektrischen Material mit geringen Verlusten gefüllt sein. Ferner kann das Gehäuse 23 auch zur Strahlformung / Fokussierung der elektromagnetischen Welle beitragen.

Sowohl Gehäuse 23 als auch Linse 21 sind zusammen und in Kombination mit allen oben erläuterten Ausführungsbeispielen / Wafer Level Packages anwendbar.

An dieser Stelle sei noch einmal zusammenfassend erwähnt, dass alle obigen Ausführungsbeispiele gemein haben, dass die Antennenschicht mit der einen oder mehreren integrierten Antenne oder Antennenarray zwischen der Dielektrikumschicht und der "Chipschicht" angeordnet ist. Diese Anordnung ermöglicht, dass sowohl die Komponenten der Chipschicht als auch die zur Kontaktierung notwendigen Bereiche der Kontaktierungsschicht relativ flexibel angeordnet werden können, da die Antenneneigenschaften in Abhängigkeit von der Dimensionierung der Antenne in der Antennenschicht und dem Dielektrikum einstellbar sind. Zur Einstellung der Antenneneigenschaften kann, wie bereits oben ausgeführt, ein zusätzliches Schild oder ein zusätzlicher Reflektor in Form eines Vias oder in Form von einer zusätzlichen Schicht, z. B. in der Kontaktierungsschicht, erfolgen. Auch kann eine Variation der Materialparameter insbesondere der Materialparameter der dielektrischen Schicht, z.B. durch Vorsehen von Permeabilitäten erfolgen.

Ein weiteres Ausführungsbeispiel bezieht sich auf ein Herstellungsverfahren für das oben erläuterte Wafer Level Package. Dieses umfasst, wie bereits angedeutet, die Schritte des Bereitstellens des Antennensubstrats umfassend die Dielektrikumschicht sowie die Antennenschicht und des Anordnens des Chiplayers umfasst zumindest einen Chip (das Antennensubstrat). Das Herstellen des Antennensubstrats kann auch mehrere Unterschritte umfassen, wie z. B. das Metallisieren der Dielektrikschicht, um die Antennenschicht herzustellen.

Die Anwendungsgebiete sind mannigfaltig. Die Plattform 10, 10', 10" bzw. das Modul kann eingesetzt werden, um drahtlose Kommunikationssysteme, die in allen Frequenzbereichen des elektromagnetischen Spektrums eingesetzt werden können, zu entwickeln, z. B. für WPAN, WLAN, Mobilfunk, Satelliten, usw.

Das kann auch eingesetzt werden, um drahtlose Sensorsysteme, die für beliebige Anwendungen in allen Frequenzbereichen des elektromagnetischen Spektrums eingesetzt werden können, zu entwickeln.

Weiterhin kann die Plattform bzw. das Modul 10-10" eingesetzt werden, um Radarsysteme, die für beliebige Anwendungen in allen Frequenzbereichen des elektromagnetischen Spektrums eingesetzt werden können, zu entwickeln.

Wie oben bereits erwähnt, kann die integrierten Antenne als Gruppenstrahler ausgeführt sein oder ein Antennenarray, z.B. mit einer Vielzahl von Antennen (>5 oder sogar >1000,) umfassen. Hier sind die mehreren Antennen bevorzugt nebeneinander so angeordnet, dass kein oder nur ein minimaler Überlapp mit weiteren Elementen, wie den Chips entsteht.

An dieser Stelle sei angemerkt, dass obige Ausführungsbeispiele nur illustrativ sind, während der Schutzbereich durch die nachfolgenden Patentansprüche festgelegt wird.

### Referenzen:

[1] T. Meyer, G. Ofner, S. Bradl, M. Brunnbauer, R. Hagen, Embedded Wafer Level Ball Grid Array (eWLB); Proceedings of EPTC 2008, Singapore.
[2] B. Keser, C. Amrine, T. Duong, O. Fay, S. Hayes, G. Leal, W. Lytle, D. Mitchell, R. Wenzel; The Redistributed Chip Package: A Breakthrough for Advanced Packaging, Proceedings of ECTC 2007, Reno/Nevada, USA.
[3] Chung-Hao Tsai et Al., Array Antenna Integrated Fan-out Wafer Level Packaging (InFO-WLP) for Millimeter Wave System Applications", 2013 IEEE International Electronic Devices Meeting (IEDM), 9-11 Dec. 2013, pp. 25.1.1 -25.1.4.
[4] Christopher Beck, et al., Industrial mmWave Radar Sensor in Embedded Wafer Level BGA Packaging Technology", IEEE SENSORS JOURNAL, VOL. 16, NO. 17, SEPTEMBER 1, 2016

## Patentansprüche

1. Wafer Level Package (10, 10', 10") mit zumindest einer integrierten Antenne (16a, 16a'), mit folgenden Merkmalen:
einer Chipschicht (12, 12') mit mindestens einem Chip (12a, 12b, 12a');
einer Dielektrikumschicht (14, 14', 14") mit zumindest einer Durchkontaktierung über ein Via; und
einer zwischen der Chipschicht (12, 12') und der Dielektrikumschicht (14, 14', 14") angeordneten Antennenschicht (16, 16') mit der zumindest einen integrierten Antenne (16a, 16a');
wobei das Wafer Level Package eine Kontaktierungsschicht (18, 18') umfasst, die auf der Dielektrikumschicht (14, 14', 14") gegenüberliegend zu der Antennenschicht (16, 16') angeordnet ist;
wobei auf der Dielektrikumschicht (14, 14', 14") ein Schild (18s') gegenüber der Antennenschicht (16, 16') angeordnet ist oder in die Kontaktierungsschicht (18, 18') integriert ist;
wobei die Chipschicht (12, 12') einen Fan-Out-Bereich (12p', 12g') umfasst;
wobei die Chipschicht (12, 12') und/oder die Dielektrikumschicht (14, 14', 14") ein Schirm-Via (16v, 14v) umfasst, das lateral zwischen der zumindest einen integrierten Antenne (16a, 16a') und dem Chip (12a, 12b, 12a') angeordnet ist und ausgebildet ist, zwischen dem Chip (12a, 12b, 12a') und der zumindest einen integrierten Antenne (16a, 16a') zu schirmen;
wobei das Schirm-Via (16v, 14v) neben dem Chip (12a, 12b, 12a') angeordnet ist;
wobei das Wafer Level Package keine Umverdrahtungsschicht umfasst.

2. Wafer Level Package (10, 10', 10") gemäß Anspruch 1, wobei die zumindest eine Antenne (16a, 16a') direkt mit dem Chip (12a, 12b, 12a') verbunden ist.

3. Wafer Level Package (10, 10', 10") gemäß Anspruch 1 oder 2, wobei die zumindest eine integrierte Antenne (16a, 16a') in der Antennenschicht (16, 16') lateral so angeordnet ist, dass eine Projektionsfläche der zumindest einen Antenne (16a, 16a') versetzt oder teilweise überlappend gegenüber einer Projektionsfläche des mindestens einen Chips ist.

4. Wafer Level Package (10, 10', 10") gemäß einem der vorherigen Ansprüche, wobei die integrierte Antenne (16a, 16a') als Gruppenstrahler ausgeführt ist oder ein Antennenarray umfasst.

5. Wafer Level Package (10, 10', 10") gemäß einem der vorherigen Ansprüche, wobei das Schild (18s') in der Projektion zumindest teilweise der zumindest einen integrierten Antenne (16a, 16a') überlappend ist.

6. Wafer Level Package (10, 10', 10") gemäß einem der vorherigen Ansprüche, wobei die Dielektrikumschicht (14, 14', 14") in einem Teil des Bereichs der zumindest einen integrierten Antenne (16a, 16a') perforiert ist.

7. Wafer Level Package (10, 10', 10") gemäß einem der vorherigen Ansprüche Anspruch, wobei der mindestens eine Chip (12a, 12b, 12a') auf einer der Dielektrikumschicht (14, 14', 14") abgewandten Seite Kühlmittel (12k) aufweist.

8. Wafer Level Package (10, 10', 10") gemäß einem der vorherigen Ansprüche, wobei der mindestens eine Chip (12a, 12b, 12a') über ein externes Bauelement mit der zumindest einen integrierten Antenne (16a, 16a') verbunden ist.

9. Wafer Level Package (10, 10', 10") gemäß einem der vorherigen Ansprüche, wobei das Wafer Level Package (10, 10', 10") eine Linse (19) umfasst, die ausgebildet ist, mit zumindest einer integrierten Antenne (16a, 16a') zusammenzuwirken.

10. System umfassend das Wafer Level Package (10, 10', 10") gemäß einem der Ansprüche 1 bis 9, wobei ein weiteres Wafer Level Package über die Kontaktierungsschicht (18, 18') mit dem Wafer Level Package (10, 10', 10") verbunden ist.

11. Verfahren zur Herstellung eines Wafer Level Package mit zumindest einer integrierten Antenne (16a, 16a'), wobei das Wafer Level Package keine Umverdrahtungsschicht umfasst, mit folgenden Schritten:
Bereitstellen einer Dielektrikumschicht (14, 14', 14") mit zumindest einer Durchkontaktierung über ein Via;
Anordnen einer Antennenschicht (16, 16') mit der zumindest einen integrierten Antenne (16a, 16a') auf der Dielektrikumschicht (14, 14', 14"); und
Anordnen einer Chipschicht (12, 12') mit mindestens einem Chip (12a, 12b, 12a') auf der Antennenschicht (16, 16') und einem Fan-Out-Bereich (12p', 12g');
Vorsehen einer Kontaktierungsschicht (18, 18'), die auf der Dielektrikumschicht (14, 14', 14") gegenüberliegend zu der Antennenschicht (16, 16') angeordnet ist
Anordnen eines Schilds (18s') auf der Dielektrikumschicht (14, 14', 14") gegenüber der Antennenschicht (16, 16') oder Integrieren eines Schilds (18s') in die Kontaktierungsschicht (18, 18');
Vorsehen Schirm-Via (16v, 14v) in der Chipschicht (12, 12') und/oder in der Dielektrikumschicht (14, 14', 14"), wobei das Schirm-Via (16v, 14v) lateral zwischen der zumindest einen integrierten Antenne (16a, 16a') und dem Chip (12a, 12b, 12a') angeordnet ist und ausgebildet ist, zwischen dem Chip (12a, 12b, 12a') und der zumindest einen integrierten Antenne (16a, 16a') zu schirmen; wobei das Schirm-Via (16v, 14v) neben dem Chip (12a, 12b, 12a') angeordnet ist.

## Claims

1. Wafer level package (10, 10', 10") with at least one integrated antenna (16a, 16a'), comprising:
a chip layer (12, 12') with at least one chip (12a, 12b, 12a');
a dielectric layer (14, 14', 14") with at least one through-connection by means of a via; and
an antenna layer (16, 16') with the at least one integrated antenna (16a, 16a') arranged between the chip layer (12, 12') and the dielectric layer (14, 14', 14");
wherein the wafer level package comprises a contacting layer (18, 18') that is arranged on the dielectric layer (14, 14', 14") opposite to the antenna layer (16, 16');
wherein a shield (18s') is arranged on the dielectric layer (14, 14', 14") opposite to the antenna layer (16, 16') or is integrated in the contacting layer (18, 18');
wherein the chip layer (12, 12') comprises a fan-out area (12p', 12g');
wherein the chip layer (12, 12') and/or the dielectric layer (14, 14', 14") comprises a shielding via (16v, 14v) that is arranged laterally between the at least one integrated antenna (16a, 16a') and the chip (12a, 12b, 12a') and is configured to shield between the chip (12a, 12b, 12a') and the at least one integrated antenna (16a, 16a');
wherein the shielding via (16v, 14v) is arranged beside the chip (12a, 12b, 12a');
wherein the wafer level package comprises no redistribution layer.

2. Wafer level package (10, 10', 10") according to claim 1, wherein the at least one antenna (16a, 16a') is directly connected to the chip (12a, 12b, 12a').

3. Wafer level package (10, 10', 10") according to claim 1 or 2, wherein the at least one integrated antenna (16a, 16a') is laterally arranged in the antenna layer (16, 16') such that a projection area of the at least one antenna (16a, 16a') is offset or partly overlapping with respect to a projection area of the at least one chip.

4. Wafer level package (10, 10', 10") according to one of the preceding claims, wherein the integrated antenna (16a, 16a') is implemented as antenna array or comprises an antenna array.

5. Wafer level package (10, 10', 10") according to one of the preceding claims, wherein the shield (18s') in the projection overlaps at least partly with the at least one integrated antenna (16a, 16a').

6. Wafer level package (10, 10', 10") according to one of the preceding claims, wherein the dielectric layer (14, 14', 14") is perforated in a part of an area of the at least one integrated antenna (16a, 16a').

7. Wafer level package (10, 10', 10") according to one of the preceding claims, wherein the at least one chip (12a, 12b, 12a') comprises cooling means (12k) on a side facing away from the dielectric layer (14, 14', 14").

8. Wafer level package (10, 10', 10") according to one of the preceding claims, wherein the at least one chip (12a, 12b, 12a') is connected to the at least one integrated antenna (16a, 16a') via an external device.

9. Wafer level package (10, 10', 10") according to one of the preceding claims, wherein the wafer level package (10, 10', 10") comprises a lens (19) that is configured to cooperate with at least one integrated antenna (16a, 16a').

10. System including the wafer level package (10, 10', 10") according to one of claims 1 to 9, wherein a further wafer level package is connected to the wafer level package (10, 10', 10") via the contacting layer (18, 18').

11. Method for manufacturing a wafer level package with at least one integrated antenna (16a, 16a'), wherein the wafer level package comprises no redistribution layer, comprising:
providing a dielectric layer (14, 14', 14") with at least one through-connection by means of a via;
arranging an antenna layer (16, 16') with the at least one integrated antenna (16a, 16a') on the dielectric layer (14, 14', 14"); and
arranging a chip layer (12, 12') with at least one chip (12a, 12b, 12a') on the antenna layer (16, 16') and a fan-out area (12p', 12g');
providing a contacting layer (18, 18') that is arranged on the dielectric layer (14, 14', 14") opposite to the antenna layer (16, 16');
arranging a shield (18s') on the dielectric layer (14, 14', 14") opposite to the antenna layer (16, 16') or integrating a shield (18s') in the contacting layer (18, 18');
providing a shielding via (16v, 14v) in the chip layer (12, 12') and/or in the dielectric layer (14, 14', 14"), wherein the shielding via (16v, 14v) is arranged laterally between the at least one integrated antenna (16a, 16a') and the chip (12a, 12b) and is configured to shield between the chip (12a, 12b, 12a') and the at least one integrated antenna (16a, 16a'), wherein the shielding via (16v, 14v) is arranged beside the chip (12a, 12b, 12a').

## Revendications

1. Ensemble de niveau de tranche (10, 10', 10") avec au moins une antenne intégrée (16a, 16a'), aux caractéristiques suivantes:
une couche de puce (12, 12') avec au moins une puce (12a, 12b, 12a');
une couche diélectrique (14, 14', 14") avec au moins une interconnexion par l'intermédiaire d'un via; et
une couche d'antenne (16, 16') disposée entre la couche de puce (12, 12') et la couche diélectrique (14, 14', 14") avec l'au moins une antenne intégrée (16a, 16a');
dans lequel l'ensemble de niveau de tranche comporte une couche de contact (18, 18') qui est disposée sur la couche diélectrique (14, 14', 14") face à la couche d'antenne (16, 16');
dans lequel un écran (18s') est disposé sur la couche diélectrique (14, 14', 14") face à la couche d'antenne (16, 16') ou intégré dans la couche de contact (18, 18');
dans lequel la couche de puce (12, 12') comporte une zone d'élargissement (12p', 12g');
dans lequel la couche de puce (12, 12') et/ou la couche diélectrique (14, 14', 14") comporte un via d'écran (16v, 14v) qui est disposé latéralement entre l'au moins une antenne intégrée (16a, 16a') et la puce (12a, 12b, 12a') et qui est conçu pour constituer un écran entre la puce (12a, 12b, 12a') et l'au moins une antenne intégrée (16a, 16a');
dans lequel le via d'écran (16v, 14v) est disposé à côté de la puce (12a, 12b, 12a');
dans lequel l'ensemble de niveau de tranche ne comporte pas de couche de recâblage.

2. Ensemble de niveau de tranche (10, 10', 10") selon la revendication 1, dans lequel l'au moins une antenne (16a, 16a') est connectée directement à la puce (12a, 12b, 12a').

3. Ensemble de niveau de tranche (10, 10', 10") selon la revendication 1 ou 2, dans lequel l'au moins une antenne intégrée (16a, 16a') est disposée latéralement dans la couche d'antenne (16, 16') de sorte qu'une surface de projection de l'au moins une antenne (16a, 16a') soit décalée par rapport à ou se trouve partiellement en recouvrement avec une surface de projection de l'au moins une puce.

4. Ensemble de niveau de tranche (10, 10', 10'') selon l'une des revendications précédentes, dans lequel l'antenne intégrée (16a, 16a') est conçue comme groupe de rayonnement ou comporte un réseau d'antennes.

5. Ensemble de niveau de tranche (10, 10', 10") selon l'une des revendications précédentes, dans lequel l'écran (18s') vient dans la projection au moins partiellement en recouvrement avec l'au moins une antenne intégrée (16a, 16a').

6. Ensemble de niveau de tranche (10, 10', 10") selon l'une des revendications précédentes, dans lequel la couche diélectrique (14, 14', 14") est perforée dans une partie de la zone de l'au moins une antenne intégrée (16a, 16a'),

7. Ensemble de niveau de tranche (10, 10', 10") selon l'une des revendications précédentes, dans lequel l'au moins une puce (12a, 12b, 12a') présente, d'un côté opposé à la couche diélectrique (14, 14', 14"), des moyens de refroidissement (12k).

8. Ensemble de niveau de tranche (10, 10', 10") selon l'une des revendications précédentes, dans lequel l'au moins une puce (12a, 12b, 12a') est connectée par l'intermédiaire d'un composant externe à l'au moins une antenne intégrée (16a, 16a').

9. Ensemble de niveau de tranche (10, 10', 10") selon l'une des revendications précédentes, dans lequel l'ensemble de niveau de tranche (10, 10', 10") comporte une lentille (19) qui est conçue pour coopérer avec au moins une antenne intégrée (16a, 16a').

10. Système comportant l'ensemble de niveau de tranche (10, 10', 10") selon l'une des revendications 1 à 9, dans lequel un autre ensemble de niveau de tranche est connecté par l'intermédiaire de la couche de contact (18, 18') avec l'ensemble de niveau de tranche (10, 10', 10").

11. Procédé de fabrication d'un ensemble de niveau de tranche avec au moins une antenne intégrée (16a, 16a'), dans lequel l'ensemble de niveau de tranche ne comporte pas de couche de recâblage, aux étapes suivantes consistant à:
prévoir une couche diélectrique (14, 14', 14") avec au moins une interconnexion par l'intermédiaire d'un via;
disposer une couche d'antenne (16, 16') avec l'au moins une antenne intégrée (16a, 16a') sur la couche diélectrique (14, 14', 14"); et
disposer une couche de puce (12, 12') avec au moins une puce (12a, 12b, 12a') sur la couche d'antenne (16, 16') et une zone d'élargissement (12p', 12g');
prévoir une couche de contact (18, 18') qui est disposée sur la couche diélectrique (14, 14', 14") face à la couche d'antenne (16, 16');
disposer un écran (18s') sur la couche diélectrique (14, 14', 14") face à la couche d'antenne (16, 16') ou intégrer un écran (18s') dans la couche de contact (18, 18');
prévoir un via d'écran (16v, 14v) dans la couche de puce (12, 12') et/ou dans la couche diélectrique (14, 14', 14"), le via d'écran (16v, 14v) étant disposé latéralement entre l'au moins une antenne intégrée (16a, 16a') et la puce (12a, 12b, 12a') et étant conçue pour constituer un écran entre la puce (12a, 12b, 12a') et l'au moins une antenne intégrée (16a, 16a'); où le via d'écran (16v, 14v) est disposé à côté de la puce (12a, 12b, 12a').
